# EUROPEAN PATENT APPLICATION

(11) **EP 4 580 376 A1**
(43) Date of publication of application: **02.07.2025**
(21) Application number: 24215747.7
(22) Date of filing: 27.11.2024
(51) Int. Cl.: H10K 59/80, H10K 59/121, H10K 59/124

(54) **TRANSPARENT DISPLAY DEVICE**

(30) Priority: 26.12.2023 KR 20230191328
(71) Applicant: LG Display Co., Ltd., Seoul 07336 (KR)
(72) Inventor: SHIM, JaeMin, Paju-si, Gyeonggi-do 10845 (KR); UHM, Mihee, Paju-si, Gyeonggi-do 10845 (KR); JEON, Seoil, Paju-si, Gyeonggi-do 10845 (KR); LEE, GeunGi, Paju-si, Gyeonggi-do 10845 (KR); KIM, WooSang, Paju-si, Gyeonggi-do 10845 (KR)
(74) Representative: Viering, Jentschura & Partner mbB Patent- und Rechtsanwälte

(57) **Abstract**

A transparent display device (100) includes a first substrate (111) and a second substrate (112) facing each other; a plurality of light emitting devices (ED) is disposed on one surface of the first substrate (111), a display area (DA) having an emission area in which the plurality of light emitting devices (ED) are disposed and a transmissive area (TA) for transmitting external light, a non-display area (NDA) disposed outside the display area (DA), an encapsulation layer (130) disposed on the plurality of light emitting devices (ED) to cover the plurality of light emitting devices (ED) and including an inorganic layer (131), and a dam (200) disposed between the first substrate (111) and the second substrate (112) in the non-display area, wherein an end portion of the inorganic layer (131) of the encapsulation layer (130) is overlapped with the dam (200).

## Description

### CROSS-REFERENCE TO RELATED APPLICATIONS

This application claims priority to Korean Patent Application No. 10-2023-0191328, filed in the Republic of Korea on December 26, 2023.

### BACKGROUND

### Technical Field

The present disclosure relates to a transparent display device.

### Discussion of the Related Art

With advancement in information-oriented societies, demands for display devices that display an image have increased in various forms. Various types of display devices such as a liquid crystal display (LCD) device, a plasma display panel (PDP) device, a Quantum dot Light Emitting Display (QLED), and an organic light emitting display (OLED) device have been widely utilized.

The display device includes two substrates, and a plurality of light emitting devices are disposed between the two substrates to display images. The light emitting devices can easily deteriorate due to external factors such as external moisture and oxygen. To prevent this, the display device includes an encapsulation layer to prevent external moisture and oxygen from penetrating the light emitting devices. When a crack occurs in the encapsulation layer, moisture can penetrate through the crack, thereby reducing the lifespan of the light emitting devices or causing a malfunction.

### BRIEF SUMMARY OF THE DISCLOSURE

The present disclosure is directed to providing a transparent display device, which substantially obviate one or more problems due to limitations and disadvantages of the related art.

An aspect of the present disclosure is directed to providing a transparent display device capable of reducing the occurrence of defects due to moisture penetration.

Another aspect of the present disclosure is directed to providing a transparent display device, which are capable of realizing ESG (Environment/Social/Governance) by reducing the generation of greenhouse gases due to the manufacturing process for producing the transparent display device.

Additional advantages and features of the disclosure will be set forth in part in the description which follows and in part will become apparent to those having ordinary skill in the art upon examination of the following or can be learned from practice of the disclosure. Other benefits of the disclosure can be realized and attained by the structure particularly pointed out in the written description and claims hereof as well as the appended drawings.

To achieve these and other advantages and in accordance with the purpose of the disclosure, as embodied and broadly described herein, there is provided a transparent display device according to claim 1. Further embodiments are described in the dependent claims. According to an aspect of the present disclosure, there is provided a transparent display device including a first substrate and a second substrate facing each other; a plurality of light emitting devices disposed on one surface of the first substrate; a display area having an emission area in which the plurality of light emitting devices are disposed and a transmissive area for transmitting external light; a non-display area disposed outside the display area; an encapsulation layer disposed on the plurality of light emitting devices to cover the plurality of light emitting devices and including an inorganic layer; and a dam disposed between the first substrate and the second substrate in the non-display area, wherein an end portion of the inorganic layer of the encapsulation layer is overlapped with the dam.

In one or more embodiments, the dam is disposed to cover the end portion of the inorganic layer of the encapsulation layer.

In one or more embodiments, the dam comprises an inner surface and an outer surface, wherein the end portion of the inorganic layer of the encapsulation layer is between the inner surface and the outer surface.

In one or more embodiments, the dam comprises an organic material and a plurality of particles distributed in the organic material.

In one or more embodiments, the plurality of particles comprise at least one of a getter absorbing moisture and a spacer having a size larger than the getter.

In one or more embodiments, the dam bonds the first substrate and the second substrate.

In one or more embodiments, the dam is disposed to surround the display area.

In one or more embodiments, the inorganic layer of the encapsulation layer is in contact with the first substrate in an area overlapping the dam.

In one or more embodiments, the transparent display device further comprises at least one organic layer disposed between the first substrate and the plurality of light emitting devices, wherein the at least one organic layer is spaced apart from the dam.

In one or more embodiments, the transparent display device further comprises circuit elements disposed between the first substrate and the plurality of light emitting devices, wherein the at least one organic layer comprises a planarization layer disposed between the circuit elements and the plurality of light emitting devices.

In one or more embodiments, the transparent display device further comprises an opening area disposed in the planarization layer in the non-display area to divide the planarization layer into at least two discontinuous portions.

In one or more embodiments, the transparent display device further comprises an inner dam pattern and an outer dam pattern disposed on one surface of the second substrate in the non-display area, the inner dam pattern and the outer dam pattern being spaced apart from each other with the dam interposed therebetween, wherein the inner dam pattern is spaced apart from the at least one organic layer on a plane.

In one or more embodiments, the transparent display device further comprises: color filters disposed on the one surface of the second substrate in the display area; and a black matrix disposed between the color filters on the one surface of the second substrate, wherein the inner dam pattern and the outer dam pattern are made of the same material as the black matrix.

In one or more embodiments, the inorganic layer of the encapsulation layer is disposed along a step difference portion disposed in the non-display area, and the step difference portion does not overlap with the dam.

In one or more embodiments, the transparent display device further comprises a gate driver disposed on the one surface of the first substrate, the gate driver being disposed at one or more sides of the display area, wherein the gate driver is disposed between the dam and the display area.

In one or more embodiments, the inorganic layer of the encapsulation layer covers the gate driver.

In one or more embodiments, the transparent display device further comprises a pad area disposed on the one surface of the first substrate, the pad area being disposed at one side of the display area, wherein an end portion of the inorganic layer of the encapsulation layer is spaced apart from the pad area with at least a portion of the dam interposed therebetween.

In one or more embodiments, an end portion of the inorganic layer of the encapsulation layer is in contact with the dam.

In one or more embodiments, the encapsulation layer comprises a plurality of inorganic layers, wherein an end portion of an uppermost inorganic layer of the encapsulation layer overlaps the dam.

In one or more embodiments, an end portion of the inorganic layer of the encapsulation layer comprises a corner portion in which a lower surface and an inclined side of the end portion meet, wherein the corner portion of the inorganic layer of the encapsulation layer overlaps the dam.

It is to be understood that both the foregoing general description and the following detailed description of the present disclosure are exemplary and explanatory and are intended to provide further explanation of the disclosure as claimed.

### BRIEF DESCRIPTION OF THE DRAWINGS

The accompanying drawings, which are included to provide a further understanding of the disclosure and are incorporated in and constitute a part of this application, illustrate embodiments of the disclosure and together with the description serve to explain the principle of the disclosure. In the drawings:
FIG. 1 is a perspective view schematically illustrating a transparent display device according to one or more embodiments of the present disclosure;
FIG. 2 is a plan view schematically illustrating a transparent display panel according to one or more embodiments of the present disclosure;
FIG. 3 is a plan view illustrating an example of sub-pixel disposed in the transparent display panel according to one or more embodiments of the present disclosure;
FIG. 4 is a plan view illustrating an example of a dam disposed in the transparent display panel according to one or more embodiments of the present disclosure;
FIG. 5 is a cross-sectional view illustrating one example taken along line I-I' illustrated in FIG. 4;
FIG. 6 is a cross-sectional view illustrating an example taken along line II-II' illustrated in FIG. 4;
FIG. 7 is a cross-sectional view illustrating an example taken along line III-III' illustrated in FIG. 4;
FIG. 8 illustrates an example in which an end portion of an inorganic layer is disposed outside a dam;
FIG. 9 illustrates an example in which an end portion of an inorganic layer is disposed between a display area and a dam; and
FIG. 10 is a cross-sectional view illustrating another example taken along line I-I' illustrated in FIG. 4.

### DETAILED DESCRIPTION OF THE EMBODIMENTS

Advantages and features of the present disclosure, and implementation methods thereof will be clarified through following embodiments described with reference to the accompanying drawings. The present disclosure can, however, be embodied in different forms and should not be construed as limited to the embodiments set forth herein. Rather, these embodiments are provided so that this disclosure will be thorough and complete, and will fully convey the scope of the present disclosure to those skilled in the art. Furthermore, the present disclosure is only defined by scopes of claims.

A shape, a size, a ratio, an angle, and a number disclosed in the drawings for describing embodiments of the present disclosure are merely an example, and thus the present disclosure is not limited to the illustrated details. Like reference numerals refer to like elements throughout. In the following description, when the detailed description of the relevant known technology is determined to unnecessarily obscure the important point of the present disclosure, the detailed description will be omitted. In a case where "comprise," "have," and "include" described in the present disclosure are used, another part can be added unless "only" is used. The terms of a singular form can include plural forms unless referred to the contrary.

In construing an element, the element is construed as including an error range although there is no explicit description.

In describing a positional relationship, for example, when a position relation between two parts is described as "on", "over", "under", and "next", one or more other parts can be disposed between the two parts unless "just" or "direct" is used.

In describing a temporal relationship, for example, when a temporal precedence relationship is described such as "after", "following", "next", "before", etc., it can include cases that are not consecutive unless "immediately" or "directly" are used.

It will be understood that, although the terms "first," "second," etc. can be used herein to describe various elements, these elements should not be limited by these terms. These terms are only used to distinguish one element from another. For example, a first element could be termed a second element, and, similarly, a second element could be termed a first element, without departing from the scope of the present disclosure.

The term "at least one" should be understood as including any and all combinations of one or more of the associated listed items. For example, the meaning of "at least one of a first item, a second item, and a third item" denotes the combination of all items proposed from two or more of the first item, the second item, and the third item as well as the first item, the second item, or the third item.

Features of various embodiments of the present disclosure can be partially or totally coupled to or combined with each other, and can be variously inter-operated and driven technically. The embodiments of the present disclosure can be carried out independently from each other or can be carried out together with a co-dependent relationship.

Hereinafter, with reference to the accompanying drawings, one example of a display device according to the present disclosure is described. In assigning reference numerals to the components in each drawing, the same component can have the same numeral as far as possible, even if it is shown in different drawings. In addition, when the detailed description of the relevant known technology is determined to unnecessarily obscure the important point of the present disclosure, the detailed description will be omitted.

Hereinafter, with reference to the accompanying drawings, one or more embodiments of the present disclosure will be described.

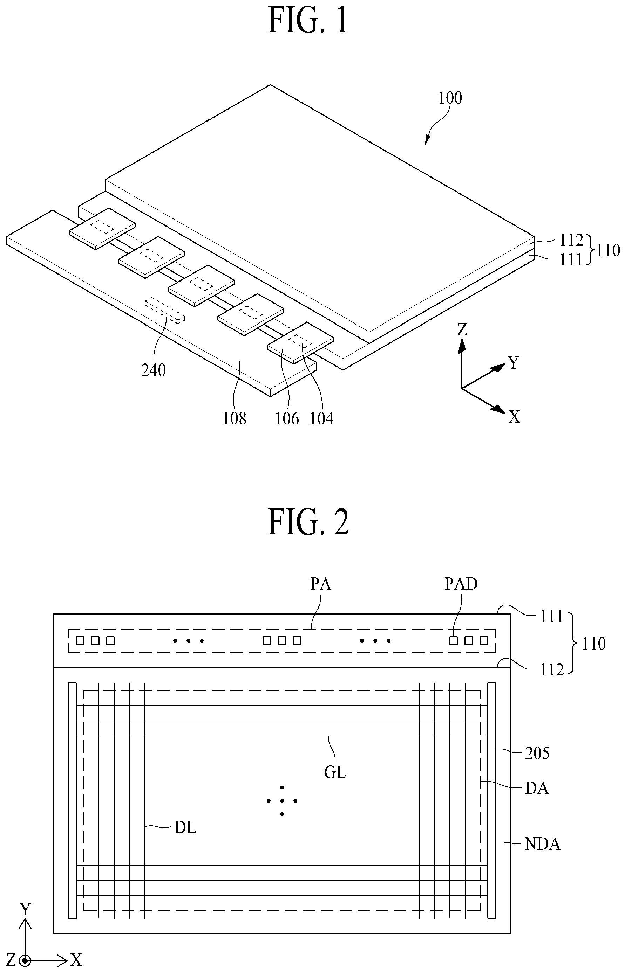

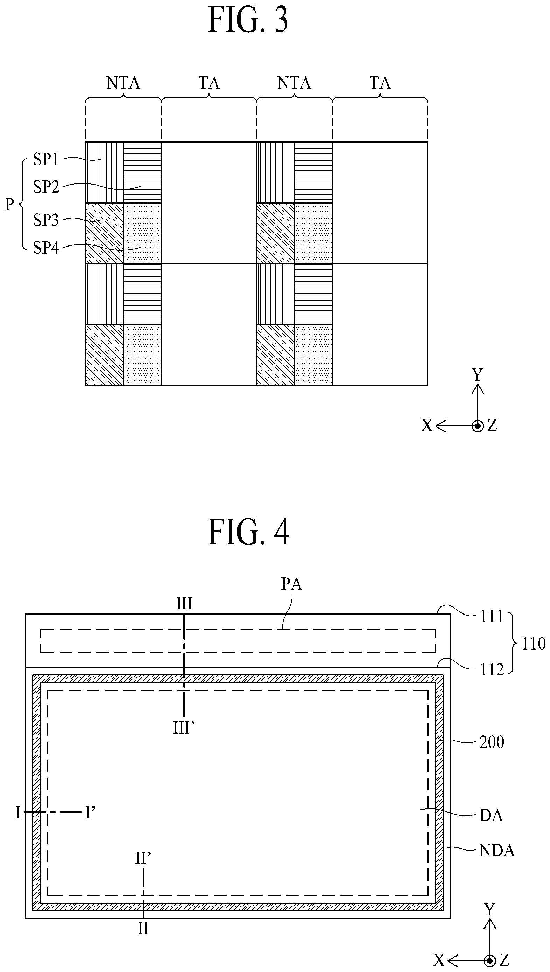

FIG. 1 is a perspective view schematically illustrating a transparent display device according to one or more embodiments of the present disclosure and FIG. 2 is a plan view schematically illustrating a transparent display panel according to one or more embodiments of the present disclosure. FIG. 3 is a plan view illustrating an example of sub-pixel disposed in the transparent display panel according to one or more embodiments of the present disclosure.

Hereinafter, an X axis represents a direction parallel to a gate line, a Y axis represents a direction parallel to a data line, and a Z axis represents a height direction of a transparent display device 100. However, other variations are possible. For example, the Y axis represents a direction parallel to a gate line, the X axis represents a direction parallel to a data line, and the Z axis represents a height direction of a transparent display device 100, and the present disclosure is not limited thereto.

An example where the transparent display device 100 according to one or more embodiments of the present disclosure is implemented as an organic light emitting display apparatus will be mainly described, but the transparent display device 100 can be implemented as a liquid crystal display (LCD) apparatus, a plasma display panel (PDP), a quantum dot light emitting display (OLED) apparatus, or an electrophoresis display apparatus.

Referring to FIGS. 1 to 3, the transparent display device 100 according to one or more embodiments of the present disclosure can include a transparent display panel 110, a source driver integrated circuit (hereinafter, referred to as "IC") 104, a flexible film 106, a circuit board 108, and a timing controller 240.

The transparent display panel 110 includes a first substrate 111 and a second substrate 112 facing each other. The second substrate 112 can be an encapsulation substrate. The first substrate 111 can be a plastic film or a glass substrate, but is not limited thereto. The first substrate 111 can be formed of a semiconductor material such as a silicon wafer. The second substrate 112 can be a plastic film, a glass substrate, or an encapsulation film.

The transparent display panel 110 can be divided into a display area DA and a non-display area NDA. The display area DA includes a plurality of pixels P and displays images. The non-display area NDA does not display the images. The non-display area NDA can partially or fully surround the display area DA. All or part of the non-display area NDA can be an area visible from the front of the transparent display panel 110, or can be an area which is bent and not visible from the front of the transparent display panel 110, but the present disclosure is not limited thereto.

Data lines DL, gate lines GL, and pixels P can be disposed in the display area DA, and a pad area PA in which pads PAD are disposed and at least one gate driver 205 can be disposed in the non-display area NDA.

The data lines DL can extend in a first direction (e.g., in a Y axis direction) and can intersect the gate lines GL in the display area DA. The gate lines GL can extend from the display area DA in a second direction (e.g., in a X axis direction).

As illustrated in FIG. 3, the display area DA can include a transmissive area TA and a non-transmissive area NTA. The transmissive area is an area in which most of the light incident from the outside is transmitted and the non-transmissive area is an area in which most of the light incident from the outside is not transmitted. For example, the transmissive area TA can be an area having a light transmittance greater than α%, and the non-transmissive area NTA can be an area having a light transmittance less than β%. In this example, α may be a value greater than β, and each of α and β can be a positive number. The transparent display device 100 can allow viewing of an object or background scenes that are located at a rear surface of the transparent display device 100 due to the transmissive area TA of the transparent display panel 110.

The non-transmissive area NTA includes a plurality of pixels P to emit predetermined light to display images. Each of the sub-pixels SP1, SP2, SP3, and SP4 can be any one of a first sub-pixel SP1 emitting red light, a second sub-pixel SP2 emitting green light, a third sub-pixel SP3 emitting blue light, and a fourth sub-pixel SP4 emitting white light, but is not limited thereto. The pixel P may include at least two sub-pixels SP1, SP2, SP3, and SP4. For example, the pixel P can include a first sub-pixel SP1, a second sub-pixel SP2, a third sub-pixel SP3, and a fourth sub-pixel SP4 as illustrated in FIG. 3. Also, the arrangement order of the sub-pixels SP1, SP2, SP3, and SP4 can be variously changed.

For example, the plurality of subpixels SP can include red, green, and blue subpixels, in which the red, green, and blue subpixels can be disposed in a repeated manner. Alternatively, the plurality of subpixels SP can include red, green, blue, and white subpixels, in which the red, green, blue, and white subpixels can be disposed in a repeated manner, or the red, green, blue, and white subpixels can be disposed in a quad type. For example, the red sub pixel, the blue sub pixel, and the green sub pixel can be sequentially disposed along a row direction, or the red sub pixel, the blue sub pixel, the green sub pixel and the white sub pixel can be sequentially disposed along the row direction. However, in the exemplary embodiment of the present disclosure, the color type, disposition type, and disposition order of the subpixels are not limiting, and can be configured in various forms according to light-emitting characteristics, device lifespans, and device specifications.

Meanwhile, the subpixels can have different light-emitting areas according to light-emitting characteristics. For example, a sub-pixel that emits light of a color different from that of a blue sub-pixel can have a different light-emitting area from that of the blue sub-pixel. For example, the red sub-pixel, the blue sub-pixel, and the green sub-pixel, or the red sub-pixel, the blue sub-pixel, the white sub-pixel, and the green sub-pixel can each have a different light-emitting area.

A plurality of pads can be disposed in the pad area PA. Since the size of the first substrate 111 is larger than the size of the second substrate 112, a portion of the first substrate 111 can be exposed and not covered by the second substrate 112. The pads such as power pads or data pads, etc., can be disposed in the portion of the first substrate 111 that is exposed and not covered by the second substrate 112. For example, the pads such as power pads or data pads, etc., can be disposed in the portion of the first substrate 111, but are not disposed on the second substrate 112 and do not overlap with the second substrate 112.

The gate driver 205 is connected to the gate line to supply a gate signal. The gate driver 205 can be formed in a gate driver in panel GIP type in the non-display area NDA outside of one side or both sides of the display area DA. Alternatively, the gate driver 205 can be fabricated as a driver chip, mounted on a flexible film, and attached to the non-display area NDA outside of one side or both sides of the display area DA in tape automated bonding TAB type.

The gate driver 205 can receive a first gate voltage corresponding to the turn-on level voltage and a second gate voltage corresponding to the turn-off level voltage along with various gate driving control signals GCS, and can generate gate signals and supply the generated gate signals to the plurality of gate lines GL.

The source driver IC 104 receives a digital video data and a source control signal from the timing controller 240. The source driver IC 104 converts the digital video data into analog data voltages according to the source control signal and supplies them to the data lines. If the source driver IC 104 is fabricated as a driver chip, it can be mounted on the flexible film 106 in a chip on film COF type or a chip on plastic COP type.

The flexible film 106 can include lines connecting the pads to the source driver IC 104 and lines connecting the pads to the wires of the circuit board 108. The flexible film 106 can be attached on the pads using an anisotropic conducting film, thereby connecting the lines of the pads and the flexible film 106.

The source driver IC 104 be connected to one side (e.g., the upper or lower side) of the transparent display panel 110. Depending on the driving method, panel design method, etc., the source driver IC 104 can be connected to both sides (e.g., upper and lower sides) of the transparent display panel 110, or can be connected to two or more of the four sides of the transparent display panel 110.

The source driver IC 104 can be connected to the outside of the display area DA of the transparent display panel 110, but alternatively, it can be disposed in the display area DA of the transparent display panel 110.

The circuit board 108 can be attached to the flexible films 220. The circuit board 108 can have a plurality of circuits implemented with driving chips mounted thereon. For example, the timing controller 240 can be mounted on the circuit board 108. The circuit board 108 can be a printed circuit board or a flexible printed circuit board.

The timing controller 240 receives the digital video data and a timing signal from an external system board. The timing controller 240 generates a gate control signal for controlling the operation timing of the gate driver and a source control signal for controlling the source driver ICs 104 based on the timing signal. The timing controller 240 supplies the gate control signal to the gate driver 205 and the source control signal to the source driver ICs 104.

The timing controller 240 can be implemented with various circuits or electronic components, such as an integrated circuit (IC), a field programmable gate array (FPGA), an application specific integrated circuit (ASIC), or Processor, but not limited thereto.

The timing controller 240 can transmit and receive signals with the source driver ICs 104 according to one or more predetermined interfaces. For example, the interface can include a low voltage differential signaling (LVDS) interface, an embedded clock point-point interface

(EPI), or a serial peripheral interface (SPI), without being limited thereto. Also, the timing controller 240 can transmit and receive signals with the gate driving circuit 130, and include a storage medium such as one or more registers.

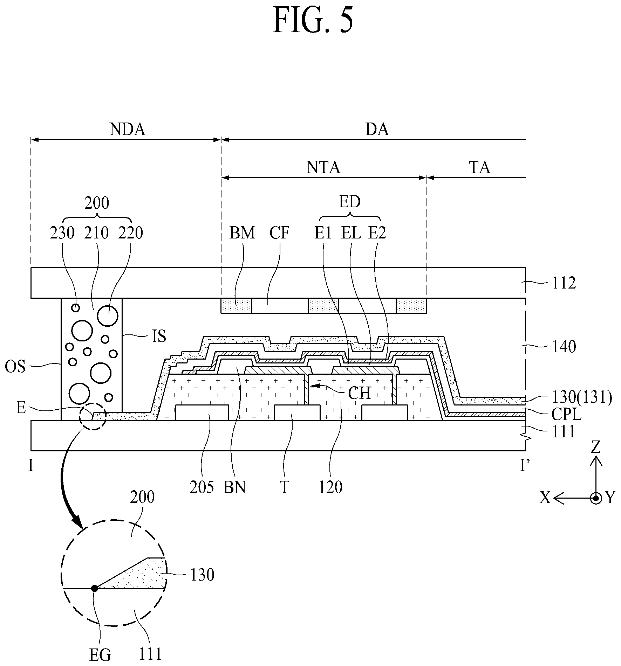

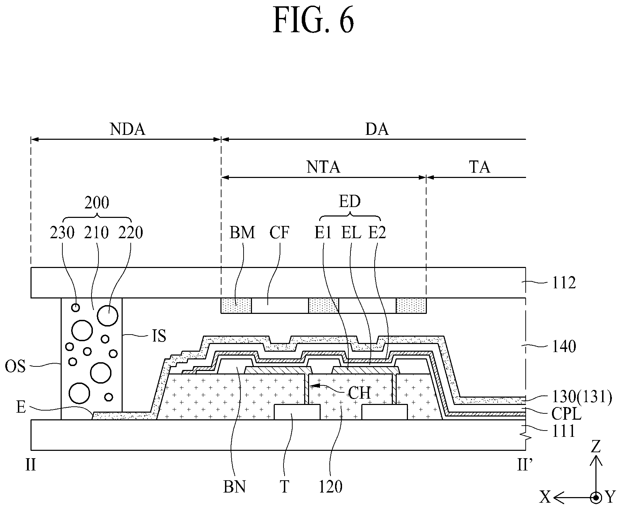

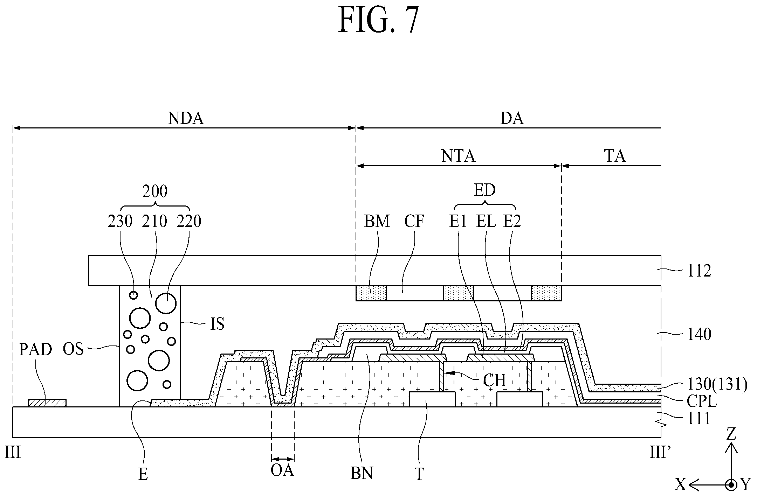

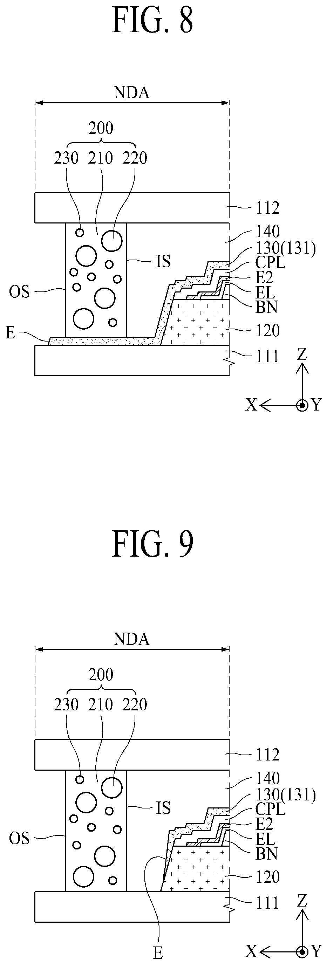

FIG. 4 is a plan view illustrating an example of a dam disposed in the transparent display panel according to one or more embodiments of the present disclosure, FIG. 5 is a cross-sectional view illustrating one example taken along line I-I' illustrated in FIG. 4, FIG. 6 is a cross-sectional view illustrating an example taken along line II-II' illustrated in FIG. 4, FIG. 7 is a cross-sectional view illustrating an example taken along line III-III' illustrated in FIG. 4. FIG. 8 illustrates an example in which an end of an inorganic layer is disposed outside a dam and FIG. 9 illustrates an example in which an end of an inorganic layer is disposed between a display area and a dam.

Referring to FIGS. 4 to 7, the transparent display panel 110 according to one or more embodiments of the present disclosure can include the display area DA and the non-display area NDA. The display area DA is provided with the pixels P that can display images.

Each of the plurality of pixels P can include a first sub-pixel SP1, a second sub-pixel SP2, a third sub-pixel SP3, and a fourth sub-pixel SP4. As illustrated in FIGS. 5 to 7, each of the first to fourth sub-pixels SP1, SP2, SP3, and SP4 can be provided with a circuit element T and a light emitting device ED between a first substrate 111 and a second substrate 112. The light emitting device ED can include a first electrode E1, an organic layer EL, and a second electrode E2.

The circuit element T is disposed on the first substrate 111. The circuit element T can include various signal lines, thin-film transistor, and capacitor, etc. The circuit element T is provided for each of the sub-pixels SP1, SP2, SP3, and SP4. The signal lines can include the gate lines, the data lines, the driving power lines, the common power lines, and the reference lines, etc. The thin film transistor can include the switching transistor, the driving transistor, and the sensing transistor.

Active layers of thin-film transistors TFTs can be formed of a semiconductor material, such as an oxide semiconductor, amorphous semiconductor, or polycrystalline semiconductor, but are not limited thereto.

The oxide semiconductor material can have an excellent effect of preventing a leakage current and relatively inexpensive manufacturing cost. The oxide semiconductor can be made of a metal oxide such as zinc (Zn), indium (In), gallium (Ga), tin (Sn), and titanium (Ti) or a combination of a metal such as zinc (Zn), indium (In), gallium (Ga), tin (Sn), or titanium (Ti) and its oxide. Specifically, the oxide semiconductor can include zinc oxide (ZnO), zinc-tin oxide (ZTO), zinc-indium oxide (ZIO), indium oxide (InO), titanium oxide (TiO), indium-gallium-zinc oxide (IGZO), indium-zinc-tin oxide (IZTO), indium zinc oxide (IZO), indium gallium tin oxide (IGTO), and indium gallium oxide (IGO), but is not limited thereto.

The polycrystalline semiconductor material has a fast movement speed of carriers such as electrons and holes and thus has high mobility, and has low energy power consumption and superior reliability. The polycrystalline semiconductor can be made of polycrystalline silicon (poly-Si), but is not limited thereto.

The amorphous semiconductor material can be made of amorphous silicon (a-Si), but is not limited thereto.

A planarization layer 120 can be disposed on the circuit element T to planarize the step difference caused by the circuit element T. The planarization layer 120 can be disposed in the display area DA. The planarization layer 120 can be disposed in the non-transmissive area NTA and cannot be disposed in at least a portion of the transmissive area TA. The planarization layer 120 can cause refraction of light as it transmits light, thereby reducing transparency. Accordingly, the transparent display panel 110 according to one or more embodiments of the present disclosure can increase transparency by removing a portion of the planarization layer 120 in the transmissive area TA.

The planarization layer 120 can extend from the display area DA to a portion of the non-display area NDA. The planarization layer 120 can be formed to cover the gate driver 205 provided in the non-display area NDA.

The planarization layer 120 can be formed of an organic insulating material such as an acrylic resin, an epoxy resin, a phenolic resin, a polyamide resin, or a polyimide resin.

The light emitting device ED and a bank BN can be disposed on the planarization layer 120. The light emitting device ED can include the first electrode E1, the organic layer EL, and the second electrode E2.

The first electrode E1 can be disposed for each of the sub-pixels SP1, SP2, SP3, and SP4 on the planarization layer 120. The first electrode E1 can be electrically connected to the circuit element T, particularly, the driving transistor DT. In detail, the first electrode E1 can be connected to one of the source electrode and the drain electrode of the driving transistor DT through a contact hole CH. The bank BN is disposed between the first electrodes E1 adjacent to each other and the first electrodes E1 adjacent to each other can be electrically insulated from each other by the bank BN.

The bank BN can be disposed at a boundary between the plurality of subpixels SP and suppress a color mixture of light beams from the plurality of subpixels SP. The bank BN can include an inorganic insulating material, such as silicon nitride (SiNx) or silicon oxide (SiOx), or an organic insulating material such as benzocyclobutene (BCB)-based resin, acrylic resin, or polyimide, for example, the bank BN can be formed of black resin. However, the present disclosure is not limited thereto.

The first electrode E1 can be formed of a highly reflective metal material such as a stacked structure of aluminum and titanium (Ti/Al/Ti), a stacked structure of aluminum and ITO (ITO/Al/ITO), an Ag alloy, a stacked structure of Ag alloy and ITO (ITO/Ag alloy/ITO), a MoTi alloy, and a stacked structure of the MoTi alloy and ITO (ITO/MoTi alloy/ITO). The Ag alloy can be an alloy such as silver Ag, palladium Pd, copper Cu, etc. The MoTi alloy can be an alloy of molybdenum Mo and titanium Ti. The first electrode E1 can be an anode electrode.

The bank BN can be disposed on the planarization layer 120. The bank BN can be formed to cover an edge of the first electrode E1 and expose a part of the first electrode E1. Accordingly, the bank BN can prevent a problem in which the light emission efficiency is deteriorated due to the concentration of current on the end of the first electrode E1.

The bank BN can define emission area of each of the subpixels SP1, SP2, SP3, and SP4. The emission area of each of the subpixels SP1, SP2, SP3, and SP4 represent areas in which the first electrode E1, the organic layer EL, and the second electrode E2 are sequentially stacked so that holes from the first electrode E1 and electrons from the second electrode E2 are coupled to each other in the organic layer EL to emit light. In this example, an area in which the bank BN is disposed does not emit light and thus becomes the non-emission area NEA, and an area in which the bank BN is not disposed and the first electrode E1 is exposed can be the emission area.

The organic layer EL can be disposed on the first electrode E1. The organic layer EL can a hole transport layer, a light emitting layer, and an electron transport layer. In this example, when a voltage is applied to the first electrode E1 and the second electrode E2, holes and electrons move to the light emitting layer through the hole transport layer and the electron transport layer, respectively, and combines with each other in the light emitting layer to emit light.

In one or more embodiments, the organic layer EL can be a common layer commonly formed in the subpixels SP1, SP2, SP3, and SP4. In this example, the light emitting layer can be a white light emitting layer emitting white light.

In another example embodiment, the light emitting layer of organic layer EL can be formed for each of the subpixels SP1, SP2, SP3, and SP4. For example, a red light emitting layer emitting red light can be formed in the first subpixel SP1, a green light emitting layer emitting green light can be formed in the second subpixel SP2, a blue light emitting layer emitting blue light can be formed in the third subpixel SP3, and a white light emitting layer emitting white light can be formed in the fourth subpixel SP4.

The second electrode E2 can be disposed on the organic layer EL and the bank BN. The second electrode E2 can be formed of a transparent metal material TCO such as ITO or IZO capable of transmitting light, or a semi-transmissive conductive material such as magnesium Mg, silver Ag, or an alloy of magnesium Mg and silver Ag. When the second electrode E2 is formed of the semi-transmissive conductive material, light emission efficiency can be increased due to a micro cavity. The second electrode E2 can be a cathode electrode.

The encapsulation layer 130 can be disposed provided on the light emitting devices ED. The encapsulation layer 130 can be formed on the second electrode E2 to cover the second electrode E2. The encapsulation layer 130 serves to prevent oxygen or moisture from penetrating into the light organic layer EL and the second electrode E2. To this end, the encapsulation layer 130 can include at least one inorganic layer 131. The encapsulation layer 130 can further include at least one organic layer. The encapsulation layer 130 has a structure in which inorganic encapsulation layers and organic encapsulation layers are alternately stacked, such that the encapsulation layer 130 can protect the light-emitting element while inhibiting moisture or oxygen from penetrating into the light-emitting element. For example, the encapsulation layer 130 can have a multi-insulating film structure in which organic films and inorganic films are stacked alternately. The inorganic film can block permeation of moisture or oxygen. The organic film can planarize a surface of the inorganic film. When the organic film and the inorganic film are stacked in multiple layers, a movement path of moisture or oxygen can be longer than that of a single layer, thereby effectively blocking the permeation of moisture and oxygen affecting the light emitting layer. In this example, the encapsulation layer 130 can have the inorganic layer 131 on its uppermost portion. The encapsulation layer 130 can cover the display area DA and can be extended from the display area DA to a portion of the non-display area NDA. The encapsulation layer 130 can be formed to cover the planarization layer 120 and the bank BN as well as the light emitting devices ED. However, the present disclosure is not limited thereto.

The inorganic layer 131 provided in the encapsulation layer 130 can be formed of a silicon oxide layer SiOx, a silicon nitride layer SiNx, or multiple layers thereof. The organic layer provided in the encapsulation layer 130 can be formed of an organic insulating material such as an acrylic resin, an epoxy resin, a phenolic resin, a polyamide resin, or a polyimide resin.

For example, the encapsulation layer 130 includes a first inorganic encapsulation layer, a first organic encapsulation layer, and a second inorganic encapsulation layer stacked sequentially. For example, the encapsulation layer 130 includes a first inorganic encapsulation layer, a first organic encapsulation layer, a second inorganic encapsulation layer, a second organic encapsulation layer, and a third inorganic encapsulation layer stacked sequentially. However, the present disclosure is not limited thereto.

The first inorganic encapsulation layer, the second inorganic encapsulation layer, and the third inorganic encapsulation layer can serve to block the penetration of moisture or oxygen. The first inorganic encapsulation layer, the second inorganic encapsulation layer, and the third inorganic encapsulation layer can be made of an inorganic material, for example, an inorganic material such as silicon nitride (SiNx), silicon oxide (SiOx), or aluminum oxide (AlOx). However, the present disclosure is not limited thereto.

The first organic encapsulation layer is disposed between the first inorganic encapsulation layer and the second inorganic encapsulation layer, and the second organic encapsulation layer is disposed between the second inorganic encapsulation layer and the third inorganic encapsulation layer. The first organic encapsulation layer and the second organic encapsulation layer can each have a larger thickness than each of the first inorganic encapsulation layer, the second inorganic encapsulation layer, and the third inorganic encapsulation layer in order to adsorb or block particles that can be produced during a process of manufacturing the display device. The first organic encapsulation layer and the second organic encapsulation layer can fill cracks that can be formed in the first inorganic encapsulation layer and the second inorganic encapsulation layer. The first organic encapsulation layer and the second organic encapsulation layer can planarize an upper portion of the first inorganic encapsulation layer and an upper portion of the second inorganic encapsulation layer by covering particles on the first inorganic encapsulation layer and the second inorganic encapsulation layer respectively. For example, the first organic encapsulation layer can planarize an upper portion of the first inorganic encapsulation layer by covering particles on the first inorganic encapsulation layer. For example, the second organic encapsulation layer can planarize an upper portion of the second inorganic encapsulation layer by covering particles on the second inorganic encapsulation layer. The first organic encapsulation layer and the second organic encapsulation layer can be made of an organic material, and for example, epoxy polymer, acrylic polymer, or the like can be used. However, the present disclosure is not limited thereto.

Meanwhile, the encapsulation layer 130 is not limited to three or five layers, for example, n layers alternately stacked between inorganic encapsulation layer and organic encapsulation layer (where n is an integer greater than 1) can be included.

A capping layer CPL can be further disposed between the light emitting devices ED and the encapsulation layer 130. The capping layer CPL can be disposed on the second electrode E2 to cover the second electrode E2. The capping layer CPL can improve viewing angle characteristics and increase external light emitting efficiency. The capping layer CPL can include at least one of an inorganic material and an organic material having light transmittance

A color filter CF can be disposed on one surface of the second substrate 112 facing the first substrate 111. The color filter CF can be patterned for each of the subpixels SP1, SP2, SP3, and SP4. For example, the color filter CF can include a first color filter, a second color filter, a third color filter, and a fourth color filter. The first color filter can be disposed to correspond to the first sub-pixel SP1, and can be a red color filter that transmits red light. The second color filter can be disposed to correspond to second sub-pixel SP2, and can be a green color filter that transmits green light. The third color filter can be disposed to correspond to the third sub-pixel SP3, and can be a blue color filter that transmits blue light. The fourth color filter can be disposed to correspond to the fourth sub-pixel SP4, and can be a white color filter that transmits white light. The white color filter can be made of a transparent organic material that transmits white light, but is not limited thereto.

A black matrix BM can be disposed between the color filters CF. The black matrix BM can be disposed between the subpixels SP1, SP2, SP3, and SP4 to prevent color mixture from being generated between adjacent subpixels SP1, SP2, SP3, and SP4. Also, the black matrix BM can prevent light incident from the outside from being reflected by a plurality of signal lines disposed between the subpixels SP1, SP2, SP3, and SP4. The black matrix BM can include a material that absorbs light, for example, a black dye that absorbs all light in the visible wavelength band.

A filler 140 can be disposed between the first substrate 111 including the light emitting devices ED and the second substrate 112 including the color filter CF and the black matrix BM. In this example, the filler 140 can use a thermosetting resin or a UV curable resin, and can be formed of an organic material having adhesive properties. In one embodiment, the filler 140 can include a material that absorbs hydrogen.

The pad area PA in which pads PAD are disposed and a dam 200 can be disposed in the non-display area NDA.

The dam 200 can be disposed between the first substrate 111 and the second substrate 112 in the non-display area NDA. The dam 200 can be formed between the first substrate 111 and the second substrate 112 to be in contact with each of the first substrate 111 and the second substrate 112, and thus the first substrate 111 and the second substrate 112 can be bonded to each other.

The dam 200 can be disposed to surround the display area DA while being spaced apart from the display area DA. The dam 200 can be disposed to be spaced apart from the edge of the second substrate 112. That is, the dam 200 can be disposed to surround the display area DA between the edge of the second substrate 112 and the display area DA.

The dam 200 can be spaced apart from the display area DA with the gate driver 205 interposed therebetween in the non-display area NDA. In this example, the dam 200 can be disposed not to overlap the gate driver 205 disposed in the non-display area NDA.

The dam 200 can block the flow of the filler 140 so that the filler 140 does not flow out. The dam 200 can have an inner surface IS and an outer surface OS. The inner surface IS can be in contact with the filler 140. The outer surface OS can be exposed to the outside and cannot be in contact with the filler 140.

The dam 200 can include an organic material 210 and a plurality of particles 220 and 230 distributed in the organic material 210. The organic material 210 can be made of various materials known in the art, such as a thermosetting resin or a UV curable resin.

The plurality of particles 220 and 230 can include at least one of a plurality of spacers 220 and a plurality of getters 230. The plurality of getters 230 can be formed of a material that absorbs moisture. The plurality of getters 230 can absorb moisture distributed in the organic material 210 and penetrated into the transparent display panel 110 from the outside. Accordingly, the plurality of getters 230 can prevent moisture from penetrating into the transparent display panel 110.

The plurality of spacers 220 can have a size larger than the plurality of getters 230. The plurality of spacers 220 can be distributed in the organic material 210 to limit a gap between the first substrate 111 and the second substrate 112 within the dam 200. Accordingly, the plurality of spacers 220 can prevent the dam 200 from collapsing due to pressure when the first substrate 111 and the second substrate 112 are combined.

In the transparent display device 100 according to one or more embodiments of the present disclosure, the encapsulation layer 130 overlaps the dam 200. Specifically, the encapsulation layer 130 includes at least one inorganic layer 131. An end portion E of the inorganic layer 131 included in the encapsulation layer 130 can overlap the dam 200. When the encapsulation layer 130 includes the plurality of inorganic layers, the end portion E of the uppermost inorganic layer 131 of the encapsulation layer 130 can overlap the dam 200.

The inorganic film layer of the encapsulation layer 130 can be formed to cover the display area DA, and can be extended from the display area DA to the non-display area NDA. In this example, the inorganic layer 131 of the encapsulation layer 130 can be extended inside the dam 200. The inorganic layer 131 of the encapsulation layer 130 can overlap a portion of the dam 200, and the end portion E can be positioned in the dam 200. The end portion E of the inorganic layer 131 can be spaced apart from the outer surface OS of the dam 200. For example, the end portion E can be disposed between the inner surface IS and the outer surface OS of the dam 200, but not limited thereto.

Unlike the transparent display panel 110 according to one or more embodiments of the present disclosure, the inorganic layer 131 of the encapsulation layer 130 can be designed to extend to the outside of the dam 200 as shown in FIG. 8. In this case, the end portion E of the inorganic layer 131 can be positioned outside the dam 200. For example, the end portion E of the inorganic layer 131 can be positioned outside the outer surface OS of the dam 200, but not limited thereto.

The inorganic layer 131 can be deposited by a chemical vapor deposition CVD. In the CVD technique, a mask is disposed on the first substrate 111, and a gas including an element constituting the inorganic layer 131 is supplied onto the first substrate 111. The supplied gas causes a chemical reaction on the surface of the first substrate 111 in a region where the mask is not disposed, and thus the inorganic layer 131 is formed on the surface of the first substrate 111 in an area where the mask is not disposed. However, in the CVD technique, since the mask is spaced apart from the first substrate 111 at a predetermined interval, the gas can partially penetrate between the mask and the first substrate 111 so that the chemical reaction can occur on the surface of the first substrate 111 in a part of an area where the mask is disposed. Accordingly, the end portion E of the inorganic layer 131 can be formed thinly under the mask. The end portion E of the inorganic layer 131 can include a corner EG where a lower surface and an inclined side meet.

Since the inorganic layer 131 has a thin end portion E, the inorganic layer 131 is vulnerable to external impact and thus cracks can be easily occurred. When the end portion E of the inorganic layer 131 is disposed outside the dam 200 and exposed to the outside, as shown in FIG. 8, the possibility of cracks due to external impact during the process increases.

Unlike the transparent display panel 110 according to one or more embodiments of the present disclosure, the inorganic layer 131 of the encapsulation layer 130 can be designed to extend between the dam 200 and the display area DA as shown in FIG. 9. In this case, the end portion E of the inorganic layer 131 can be disposed between the dam 200 and the display area DA.

A plurality of layers provided in the display area DA can extend to a part of the non-display area NDA between the dam 200 and the display area DA. For example, the planarization layer 120, the organic layer EL and the second electrode E2 of the light emitting device ED, and the capping layer CPL can extend from the display area DA to the part of the non-display area NDA.

The inorganic layer 131 of the encapsulation layer 130 can be preferably disposed to cover all layers extended to the non-display area NDA for encapsulation performance. However, even if the inorganic layer 131 of the encapsulation layer 130 is designed to cover all layers disposed under the encapsulation layer 130, the inorganic layer 131 cannot cover at least a portion of the layer disposed under the encapsulation layer 130 due to a process error.

For example, the inorganic layer 131 cannot completely cover the planarization layer 120 disposed in the non-display area NDA as shown in FIG. 9, and the end portion E can be disposed on the side surface of the planarization layer 120. At least a portion of the side surface of the planarization layer 120 cannot be covered by the inorganic layer 131 and can be exposed. Moisture can easily penetrate into the planarization layer 120 through the exposed side surface and can propagate to the area where the light emitting device ED is provided through the planarization layer 120. As a result, deterioration of the light emitting device ED can occur and lifespan of the light emitting device ED can be reduced.

On the other hand, if the end portions between the layers disposed under the inorganic layer 131 and the encapsulation layer 130 are designed to be sufficiently spaced apart in consideration of process errors, the width of the non-display area NDA can increase, thereby reducing the area of the display area DA.

In the transparent display panel 110 according to one or more embodiments of the present disclosure, the end portion E of the inorganic layer 131 of the encapsulation layer 130 can be disposed in the dam 200. The end portion E of the inorganic layer 131 can include the corner portion EG at which a lower surface and an inclined side meet. In the transparent display panel 110 according to one or more embodiments of the present disclosure, the corner portion EG of the inorganic layer 131 can be overlapped with the dam 200. In the transparent display panel 110 according to one or more embodiments of the present disclosure, the end portion E of the inorganic layer 131 can be directly contacted to the dam 200 and can be covered by the dam 200. Accordingly, in the transparent display panel 110 according to one or more embodiments of the present disclosure, the width of the non-display area NDA can be reduced and the area of the display area DA can be increased. Also, in the transparent display panel 110 according to one or more embodiments of the present disclosure, the possibility that a crack occurs at the end portion E of the inorganic film 131 can be reduced.

In the transparent display panel 110 according to one or more embodiments of the present disclosure, an element made of an organic material can be spaced apart from the dam 200. In this example, the element made of the organic material can be one of the elements made of the organic material among elements provided in the display area DA. As an example, the planarization layer 120 can be disposed to be spaced apart from the dam 200. As another example, the bank BN can be disposed to be spaced apart from the dam 200. When there is an element made of the organic material other than the planarization layer 120 and the bank BN in the display area DA, the element can also be disposed to be spaced apart from the dam 200.

Since the end portion E of the inorganic layer 131 according to one or more embodiments of the present disclosure is not exposed to the outside, an external impact cannot be directly applied. That is, the inorganic layer 131 according to one or more embodiments of the present disclosure cannot have a high possibility of cracking. However, in the dam 200, large and small particles such as the spacer 220 and the getter 230 are distributed in the organic material 210. Particles such as the spacer 220 and the getter 230 can collide with the inorganic layer 131 when an external impact is applied. In this case, cracks can occur due to particles such as the spacer 220 and the getter 230 at the end portion E formed to have a relatively thin thickness.

As such, cracks can occur in an area in which the inorganic layer 131 and the dam 200 overlap each other. Thus, the transparent display panel 110 according to one or more embodiments of the present disclosure prevents an organic material from being disposed in a lower portion of the area where the inorganic layer 131 overlaps the dam 200. Specifically, in the transparent display panel 110 according to one or more embodiments of the present disclosure, the planarization layer 120 and the bank BN cannot be disposed in the area where the inorganic layer 131 and the dam 200 overlap each other.

For example, an end portion of the planarization layer 120 formed in the non-display area NDA can be spaced apart from the inner surface IS of the dam 200 by a first distance. Also, an end portion of the bank BN formed in the non-display area NDA can be spaced apart from the inner surface IS of the dam 200 by a second distance. The first distance and the second distance can be the same or different from each other. The first distance can be smaller than the second distance, but is not necessarily limited thereto. The first distance can be greater than the second distance.

An organic material layer such as the planarization layer 120 and the bank BN are vulnerable to moisture, and moisture can propagate through the organic material layer to the display area DA. The inorganic layer 131 can block external moisture by covering the organic material layer having such characteristics. However, when a crack occurs in the inorganic layer 131 deposited on an upper portion of the organic material layer, the organic material layer can be exposed between the cracks of the inorganic layer 131. Moisture can penetrate into the organic material layer through the crack of the inorganic layer 131.

Since there is possibility that cracks can occur in the area where the inorganic layer 131 and the dam 200 overlap each other, in the transparent display panel 110 according to one or more embodiments of the present disclosure, an organic material layer, for example, the planarization film 120 or a bank BN can be spaced apart from the dam 200, and the inorganic layer 131 can be disposed to contact with the first substrate 111 in the area where the inorganic layer 131 and the dam 200 overlap each other. Accordingly, in the transparent display panel 110 according to one or more embodiments of the present disclosure, even if cracks occur in the area where the inorganic layer 131 and the dam 200 overlap each other, the organic material layer cannot be exposed to external moisture.

Furthermore, even if moisture propagates toward the display area DA through the crack of the inorganic layer 131, the moisture propagation speed is very slow compared to the organic material layer, and since the part where the crack has occurred and the organic material layer are separated by a predetermined distance, the time for moisture to penetrate to the organic material layer can be very long. As a result, in the transparent display panel 110 according to the one or more embodiments of the present disclosure, even if cracks occur in the area where the inorganic layer 131 and the dam 200 overlap each other, the lifespan of the light emitting device ED can be increased because the time for moisture to reach the light emitting device ED is increased.

In the transparent display panel 110 according to one or more embodiments of the present disclosure, a moisture penetration path can be blocked by forming the opening area OA in the organic material layer disposed in the non-display area NDA. Specifically, in the transparent display panel 110 according to one or more embodiments of the present disclosure, the opening area OA can be disposed in the planarization layer 120 as shown in FIG. 7. In this example, the opening area OA can be disposed between the dam 200 and the display area DA. That is, in the transparent display panel 110 according to one or more embodiments of the present disclosure, planarization layer 120 cannot be continuously formed from an end portion of the planarization layer 120 to the display area DA due to the opening area OA. For example, the planarization layer 120 can be divided into at least two portions spaced from each other through the opening area OA, but not limited thereto.

In the transparent display panel 110 according to one or more embodiments of the present disclosure, even if moisture reaches the end portion of the planarization layer 120 through the crack of the inorganic layer 131, moisture can be prevented from propagating to the planarization layer 120 disposed in the display area DA due to the opening area OA.

The planarization layer 120 according to one or more embodiments of the present disclosure can have the opening area OA on at least one side of the display area DA. The display area DA can include a first side facing the pad area PA1, a second side opposite to the first side, and a third and fourth side facing the gate driver 205. The planarization layer 120 can have the opening area OA on at least one of the first to fourth sides of the display area DA. For example, when the non-display area NDA is disposed to fully surround the display area, the planarization layer 120 can have the opening area OA on all of the first to fourth sides of the display area DA, but not limited thereto.

In an embodiment, the planarization layer 120 can have the opening area OA on the first side of the display area DA. The planarization layer 120 cannot have the opening area OA on the second to fourth sides of the display area DA.

In order to implement a narrow bezel, the display area DA can have a small separation distance from the dam 200 on the second to fourth sides of the display area DA. Accordingly, since a separation distance between the end portion of the planarization layer 120 and the display area DA is small on the second to fourth sides of the display area DA, it is difficult to form the opening area OA. Also, in order to form the opening area OA in the planarization layer 120, the separation distance between the display area DA and the dam 200 has to be increased, thereby increasing the bezel area. The planarization layer 120 cannot have the opening area OA on the second to fourth sides of the display area DA in order not to increase the width of the bezel area, that is, the non-display area NDA.

In contrast, a non-display area NDA having a relatively wide width can be disposed on the first side of the display area DA in order to dispose signal lines to be connected to the pads PAD. Since the separation distance between the end portion of the planarization layer 120 and the display area DA is relatively large on the first side of the display area DA, the opening area OA can be formed without increasing the width of the non-display area NDA.

Furthermore, in the transparent display panel 110 according to one or more embodiments of the present disclosure, a step difference portion cannot be disposed in an area overlapping the dam 200. In the display area DA, the step difference portion can occur when the circuit element, the planarization layer 120, the light emitting element ED, and the capping layer CPL are formed on the first substrate 111. Since the plurality of layers disposed in the display area DA can be extended to the non-display area NDA, and the step difference portion can also occur in the non-display area NDA. The inorganic layer 131 of the encapsulation layer 130 can be disposed in the display area DA and the non-display area NDA along the step difference portion.

In the transparent display panel 110 according to one or more embodiments of the present disclosure, the step difference portion can be disposed not to overlap with the dam 200. When the step difference portion is disposed in an area in which the dam 200 is disposed, the inorganic layer 131 can be disposed along the step difference portion even in the area in which the dam 200 is disposed. In this example, the inorganic layer 131 can be deposited thinner on the step difference portion than on the flat surface. The spacer 220 or the getter 230 distributed in the dam 200 can be caught in the step difference portion disposed in the area in which the dam 200 is disposed, thereby causing a crack in the inorganic layer 131 thinly deposited on the step difference portion.

In the transparent display panel 110 according to one or more embodiments of the present disclosure, since the step difference portion can be disposed not to overlap with the dam 200, it is possible to reduce the possibility of cracks occurring in the inorganic layer 131.

In the transparent display panel 110 according to one or more embodiments of the present disclosure, the occurrence of defects due to moisture penetration can be reduced, and thus the lifespan of the light emitting device can be increased. In addition, in the transparent display panel 110 according to one or more embodiments of the present disclosure, since the lifespan of the product can be increased, the manufacturing process cost can be reduced and the manufacturing process time can be shortened, and thus the production energy can be reduced. Further, in the transparent display panel 110 according to one or more embodiments of the present disclosure, the generation of greenhouse gases due to the manufacturing process can be reduced, thereby implementing ESG (Environment/Social/Governance).

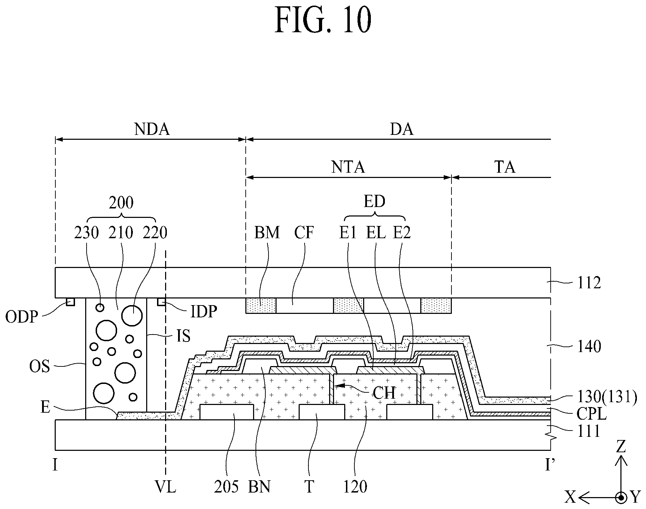

FIG. 10 is a cross-sectional view illustrating another example taken along line I-I' illustrated in FIG. 4.

Referring to FIG. 10, the transparent display panel 110 according to one or more embodiments of the present disclosure can further include an inner dam pattern IDP and an outer dam pattern ODP disposed in the non-display area NDA.

The outer dam pattern ODP can be disposed outside the dam 200 in the non-display area NDA. The outer dam pattern ODP can be disposed adjacent to the outer surface OS of the dam 200 to block the flow of the dam 200 so that the dam 200 does not overflow to the outside.

The outer dam pattern ODP can be spaced apart from the dam 200 as shown in FIG. 10, but is not limited thereto. The outer dam pattern ODP can be in contact with the outer surface OS of the dam 200 due to a process error. Even if the process error occurs, the dam 200 is not formed beyond the outer dam pattern ODP.

The inner dam pattern IDP can be disposed between the dam 200 and the display area DA in the non-display area NDA. The inner dam pattern IDP can be disposed adjacent to the inner surface IS of the dam 200 to block the flow of the dam 200 so that the dam 200 does not spread toward the display area DA.

The inner dam pattern IDP can be spaced apart from the dam 200 as shown in FIG. 10, but is not limited thereto. The inner dam pattern IDP can also be in contact with the inner surface IS of the dam 200 due to the process error. Even if the process error occurs, the dam 200 is not formed beyond the inner dam pattern IDP.

For example, the dam 200 can be formed between the inner dam pattern IDP and the outer dam pattern ODP, even when the dam 200 can be in contact with the inner dam pattern IDP and the outer dam pattern ODP.

In the transparent display panel 110 according to another embodiment of the present disclosure, an element made of an organic material can be disposed to be spaced apart from the inner dam pattern IDP. In this example, the element made of the organic material can be one of the elements made of the organic material among elements disposed in the display area DA. As an example, the planarization layer 120 can be disposed to be spaced apart from the inner dam pattern IDP. As another example, the bank BN can be disposed to be spaced apart from the inner dam pattern IDP. When there is other element made of organic material other than the planarization layer 120 and the bank BN in the display area DA, the other element can also be disposed to be spaced apart from the inner dam pattern IDP.

As such, cracks can occur in an area in which the inorganic layer 131 and the dam 200 overlap each other. Thus, the transparent display panel 110 according to another embodiment of the present disclosure prevents an organic material from being disposed below the area in which the inorganic layer 131 and the dam 200 overlap each other. Specifically, in the transparent display panel 110 according to another embodiment of the present disclosure, the planarization layer 120 and the bank BN cannot be disposed in an area in which the inorganic layer 131 and the dam 200 overlap each other.

The location of the dam 200 can be varied due to the process error. However, even if the process error occurs in the dam 200, since the flow of the dam 200 is blocked by the inner dam pattern IDP, the dam 200 cannot be formed beyond the inner dam pattern IDP.

In the transparent display panel 110 according to another embodiment of the present disclosure, the planarization layer 120 and the bank BN can be spaced apart from the inner dam pattern IDP in a plane view. That is, the planarization layer 120 and the bank BN can be spaced apart from a vertical line VL extending vertically form the inner surface of the inner dam pattern IDP without overlapping. Accordingly, the transparent display panel 110 according to another embodiment of the present disclosure can ensure that the dam 200, the planarization layer 120, and the bank BN do not overlap even when the process error occurs.

For example, the planarization layer 120 can have an end portion formed in the non-display area NDA and spaced apart from the inner surface of the inner dam pattern IDP by a first distance. In addition, the bank BN can have an end portion formed in the non-display area NDA and spaced apart from the inner surface of the inner dam pattern IDP by a second distance. The first distance and the second distance can be the same or different from each other. The first distance can be smaller than the second distance, but is not necessarily limited thereto. The first distance can be greater than the second distance.

In the transparent display panel 110 according to another embodiment of the present disclosure, since the organic material layer, for example, the planarization layer 120 or the bank BN can be disposed to be spaced apart from the inner dam pattern IDP, even if the crack occurs in the area in which the inorganic layer 131 and the dam 200 overlap each other, the organic material layer cannot be exposed to external moisture.

The outer dam pattern ODP and the inner dam pattern IDP can include the same material as the black matrix BM. The outer dam pattern ODP and the inner dam pattern IDP can include a material that absorbs light, such as the black matrix BM, for example, a black dye that absorbs all light in the visible wavelength band. The outer dam pattern ODP and the inner dam pattern IDP can be formed through the same process as the black matrix BM. In the embodiment in which the outer dam pattern ODP and the inner dam pattern IDP are formed by the same process as the black matrix BM, a separate process for forming the outer dam pattern ODP and the inner dam pattern IDP can be unnecessary.

In the present disclosure, by disposing the end portion of the inorganic layer of the encapsulation layer inside the dam, the width of the non-display area can be reduced and the area of the display area can be increased.

Moreover, in the present disclosure, the possibility of cracks occurring at the end portion of the inorganic layer of the encapsulation layer can be reduced.

Moreover, in the present disclosure, since an organic material layer, for example, the planarization layer or the bank, is disposed to be spaced apart from the dam, even if a crack occurs in the inorganic layer, the organic material layer cannot be exposed to external moisture through the crack.

Moreover, in the present disclosure, the occurrence of defects due to moisture penetration can be reduced, and thus the lifespan of the light emitting device can be increased. In addition, in the present disclosure, since the lifespan of the product can be increased, the manufacturing process cost can be reduced and the manufacturing process time can be shortened, and thus the production energy can be reduced. Further, in the present disclosure, the generation of greenhouse gases due to the manufacturing process can be reduced, thereby implementing ESG (Environment/Social/Governance).

The above-described feature, structure, and effect of the present disclosure are included in at least one embodiment of the present disclosure, but are not limited to only one embodiment. Furthermore, the feature, structure, and effect described in at least one embodiment of the present disclosure can be implemented through combination or modification of other embodiments by those skilled in the art. Therefore, content associated with the combination and modification should be construed as being within the scope of the present disclosure.

It will be apparent to those skilled in the art that various modifications and variations can be made in the present disclosure without departing from the scope of the disclosure. Thus, it is intended that the present disclosure covers the modifications and variations of this disclosure.

The various embodiments described above can be combined to provide further embodiments. These and other changes can be made to the embodiments in light of the above-detailed description. In general, in the following claims, the terms used should not be construed to limit the claims to the specific embodiments disclosed in the specification and the claims, but should be construed to include all possible embodiments. Accordingly, the claims are not limited by the disclosure.

## Claims

1. A transparent display device (100), comprising:
a first substrate (111) and a second substrate (112) facing each other;
a plurality of light emitting devices (ED) disposed on one surface of the first substrate (111);
a display area (DA) having an emission area in which the plurality of light emitting devices (ED) are disposed and a transmissive area (TA) for transmitting external light;
a non-display area (NDA) disposed outside the display area (DA);
an encapsulation layer (130) disposed on the plurality of light emitting devices (ED) to cover the plurality of light emitting devices (ED) and including an inorganic layer (131); and
a dam (200) disposed between the first substrate (111) and the second substrate (112) in the non-display area (NDA),
wherein an end portion of the inorganic layer (131) of the encapsulation layer (130) is overlapped with the dam (200).

2. The transparent display device (100) of claim 1, wherein the dam (200) is disposed to cover the end portion (E) of the inorganic layer (131) of the encapsulation layer (130).

3. The transparent display device (100) of any of claims 1 to 2, wherein the dam (200) comprises an inner surface (IS) and an outer surface (OS), and
wherein the end portion (E) of the inorganic layer (131) of the encapsulation layer (130) is between the inner surface (IS) and the outer surface (OS).

4. The transparent display device (100) of any of claims 1 to 3, wherein the dam (200) comprises an organic material (210) and a plurality of particles (220) distributed in the organic material (210).

5. The transparent display device (100) of claim 4, wherein the plurality of particles (220) comprise at least one of a getter absorbing moisture and a spacer having a size larger than the getter.

6. The transparent display device (100) of any of claims 1 to 5, wherein the dam (200) bonds the first substrate (111) and the second substrate (112), and/or
wherein the dam (200) is disposed to surround the display area (DA).

7. The transparent display device (100) of any of claims 1 to 6, wherein the inorganic layer (131) of the encapsulation layer (130) is in contact with the first substrate (111) in an area overlapping the dam (200).

8. The transparent display device (100) of any of claims 1 to 7, further comprising at least one organic layer (120) disposed between the first substrate (111) and the plurality of light emitting devices (ED),
wherein the at least one organic layer (120) is spaced apart from the dam (200).

9. The transparent display device (100) of claim 8, further comprising circuit elements (T) disposed between the first substrate (111) and the plurality of light emitting devices (ED),
wherein the at least one organic layer (120) comprises a planarization layer (120) disposed between the circuit elements (T) and the plurality of light emitting devices (ED).

10. The transparent display device (100) of claims 8 or 9, further comprising an opening area (OA) disposed in the planarization layer (120) in the non-display area (NDA) to divide the planarization layer (120) into at least two discontinuous portions.

11. The transparent display device (100) of claim 8 or 9, further comprising an inner dam pattern (IDP) and an outer dam pattern (ODP) disposed on one surface of the second substrate (112) in the non-display area (NDA), the inner dam pattern (IDP) and the outer dam pattern (ODP) being spaced apart from each other with the dam (200) interposed therebetween,
wherein the inner dam pattern (IDP) is spaced apart from the at least one organic layer (120) on a plane.

12. The transparent display device (100) of claim 11, further comprising:
color filters (CF) disposed on the one surface of the second substrate (112) in the display area (DA); and
a black matrix (BM) disposed between the color filters (CF) on the one surface of the second substrate (112),
wherein the inner dam pattern (IDP) and the outer dam pattern (ODP) are made of the same material as the black matrix (BM).

13. The transparent display device (100) of any of claims 1 to 12 wherein the inorganic layer (131) of the encapsulation layer (130) is disposed along a step difference portion disposed in the non-display area (NDA), and
wherein the step difference portion does not overlap with the dam (200).

14. The transparent display device (100) of any of claims 1 to 13, further comprising a gate driver (205) disposed on the one surface of the first substrate (111), the gate driver (205) being disposed at one or more sides of the display area (DA),
wherein the gate driver (205) is disposed between the dam (200) and the display area (DA),
wherein, preferably, the inorganic layer (131) of the encapsulation layer (130) covers the gate driver (205).

15. The transparent display device (100) of any of claims 1 to 14, further comprising a pad area (PA) disposed on the one surface of the first substrate (111), the pad area (PA) being disposed at one side of the display area (DA),
wherein an end portion of the inorganic layer (131) of the encapsulation layer (130) is spaced apart from the pad area (PA) with at least a portion of the dam (200) interposed therebetween.

16. The transparent display device (100) of any of claims 1 to 15, wherein an end portion of the inorganic layer (131) of the encapsulation layer (130) is in contact with the dam (200).

17. The transparent display device (100) of any of claims 1 to 16, wherein the encapsulation layer (130) comprises a plurality of inorganic layers (131), and
wherein an end portion of an uppermost inorganic layer of the encapsulation layer (130) overlaps the dam (200).

18. The transparent display device (100) of any of claims 1 to 17, wherein an end portion of the inorganic layer (131) of the encapsulation layer (130) comprises a corner portion in which a lower surface and an inclined side of the end portion meet, and
wherein the corner portion of the inorganic layer (131) of the encapsulation layer (130) overlaps the dam (200).
